# EUROPÄISCHE PATENTANMELDUNG

(11) **EP 4 654 408 A2**
(43) Veröffentlichungstag der Anmeldung: **26.11.2025**
(21) Anmeldenummer: 25177166.3
(22) Anmeldetag: 19.05.2025
(51) Int. Cl.: H02H 3/00, H02H 3/34, H02H 5/10

(54) **VORRICHTUNG UND VERFAHREN ZUR ERKENNUNG VON FEHLERZUSTÄNDEN EINES NEUTRALLEITERS ODER EINER NEUTRALLEITERSCHIENE**

(30) Priorität: 24.05.2024 DE 102024114662; 17.02.2025 DE 102025105735
(71) Anmelder: Doepke Schaltgeräte GmbH, 26506 Norden (DE)
(72) Erfinder: Janssen, Jörn, 26548 Norderney (DE)

(57) **Zusammenfassung**

Zur Erkennung von Fehlerzuständen eines Neutralleiters (N) eines dreiphasigen Niederspannungsnetzes wird mittels einer Vorrichtung (1) ein Verfahren durchgeführt. Hierzu wird ein Bezugspotential gebildet, und eine Spannung (V_{N)} zwischen dem Bezugspotential und dem Neutralleiter (N) gemessen. Es können Fehlerzustände des Neutralleiters (N) auf der Erzeugerseite und/oder Fehlerzustände der Neutralleiterschiene (17N) erkannt werden, wobei die Bewertung auch frequenzabhängig erfolgen kann.

## Beschreibung

Die Erfindung betrifft eine Vorrichtung und ein Verfahren zur Erkennung von Fehlerzuständen eines Neutralleiters bzw. einer Neutralleiterschiene.

Vorrichtungen zur Erkennung von Fehlerzuständen eines Neutralleiters N eines Niederspannungsnetzes, im Folgenden auch als Neutralleiterüberwachungen bezeichnet, sind als eigenständige Vorrichtungen im Stand der Technik bekannt. Zudem ist aus der AT510817A2 eine Neutralleiterüberwachung bekannt, welche Bestandteil eines Schutzschaltgerätes ist. Im Folgenden werden solche Einrichtungen näher erläutert und aus dem Stand der Technik bekannte nachteilige Vorrichtungen zur Erkennung von Fehlerzuständen eines Neutralleiters N sowie auch Vorteile der erfindungsgemäßen Vorrichtung und Ausgestaltungen aufgeführt.

Schutzschaltgeräte werden zum Personenschutz und zum Schutz elektrischer Anlagen eingesetzt. Dabei schützen unterschiedliche Schutzschaltgeräte vor unterschiedlichen elektrischen Fehlerfällen bzw. Überlastungen. Die gängigsten Schutzschaltgeräte sind Leitungsschutzschalter, welche bei Kurzschlussströmen und Überlastströmen schützen sowie Fehlerstromschutzschalter, welche bei Fehlerströmen schützen, sowie Kombinationen hieraus. Erkennt das Schutzschaltgerät einen Fehlerfall oder eine unzulässige Betriebssituation wird die zu schützende elektrische Leitung entsprechend vorgegebener Kennlinien getrennt. Ebenso ist das einzusetzende Schutzschaltgerät durch Errichtungsbestimmungen vorgegeben.

Dem Neutralleiter kommt in einem mehrphasigen Netz die Aufgabe zu, bei ungleichen Strömen in den Außenleitern die Asymmetrie auszugleichen und hierzu einen Strom zu führen, der dem Grad der Asymmetrie entspricht. In diesem Fall führt der Neutralleiter einen Strom bei Netzfrequenz, welcher maximal dem größten Strom eines Außenleiters entspricht. Bei einer unterschiedlichen Phasenverschiebung der Ströme in den Außenleitern kann der Strom im Neutralleiter den Strom in den Außenleitern deutlich übertreffen.

Wird in einem mehrphasigen Netz der Neutralleiter überlastet oder sogar unterbrochen, führt dies bei asymmetrischer Belastung der einzelnen Außenleiter zu einer Verschiebung des Sternpunkts, was zu Überspannungsschäden an den angeschlossenen Geräten führen kann.

In Verteilerkästen ist es üblich, den Neutralleiter über eine Neutralleiterschiene zu führen. Hierbei wird üblicherweise hinter einem Schutzschaltgerät, insbesondere hinter einem Fehlerstromschutzschalter, der Neutralleiter auf eine Verteilerschiene geschaltet, welche den Sternpunkt für die durch das Schutzschaltgerät geschützten Stromkreise bildet. An dieser Schiene werden dann alle untergeordneten Stromkreise, und somit die an die Stromkreise angeschlossenen elektrischen Lasten, angeschlossen.

Durch die gegenwärtigen Bemühungen im Klimaschutz werden verstärkt Änderungen an Hausinstallationen vorgenommen, wenn zum Beispiel durch den Einbau von Solaranlagen, Wärmepumpen, Ladestationen, etc. die Verteilerkästen an die neuen Lasten angepasst werden müssen. Hierdurch steigt das Risiko für Fehler, wenn zum Beispiel Neutralleiter oder Außenleiter nicht oder fehlerhaft angeschlossen werden. Gleichzeitig kommt es durch die Vielzahl an verschiedenen größtenteils nicht-ohmschen Lasten verstärkt zu asymmetrischen Stromverteilungen in den Außenleitern.

In den letzten Jahren beobachten die Versicherer eine ansteigende Anzahl von durch asymmetrische Stromverteilung bei fehlendem Neutralleiter hervorgerufenen Überspannungsschäden.

Solche Fehler können dabei sowohl auf der Netzseite, als auch auf der Verbraucherseite entstehen. Es ist daher wünschenswert sowohl die einspeiseseitige Zuleitung, als auch die verbraucherseitige Neutralleiterschiene überwachen zu können, und im Falle eines Fehlerzustandes Gegenmaßnahmen treffen zu können.

Die Anmelderin hat außerdem festgestellt, dass die erzeugten asymmetrischen Spannungen Frequenzanteile außerhalb der Netzfrequenz enthalten können, wobei auch möglich ist, dass die am Sternpunkt gemessene Spannung gar keine Komponente mit Netzfrequenz enthält, wohl aber Komponenten mit Frequenzen außerhalb der Grundfrequenz der Netzspannung. Eine herkömmliche Überspannungsschutzeinrichtung erkennt diese Fehler nicht.

Außerdem können angeschlossene Geräte und Anlagen bei unterschiedlichen Frequenzen unterschiedlich empfindlich auf Überspannung reagieren. Es ist dabei besonders vorteilhaft, wenn die Überwachung und Bewertung frequenzabhängig geschieht und zu treffende Gegenmaßnahmen, also zum Beispiel eine Abschaltung, durch Vergleich mit einem frequenzabhängigen Referenzwert ausgelöst werden.

Im Stand der Technik, wie er zum Beispiel in EP4300112A1 dargestellt ist, ist es hierzu üblich die Spannung der einzelnen Außenleiter gegenüber dem Neutralleiter zu messen und hieraus einen Indikator zu berechnen, welcher mit einem Referenzwert verglichen wird. Alternativ hierzu kann aus Strom und Spannungswerten auch eine Impedanz berechnet werden, wie dies in EP4300112A1 geschieht. Bei einer Erhöhung der Impedanz wird hier auf eine Neutralleiterunterbrechung geschlossen und der Stromkreis geöffnet. Nachteilig hierbei ist, dass alle beteiligten Phasenspannungen und gegebenenfalls auch noch die Stromwerte gemessen werden müssen, worauf sich im Stand der Technik ein Berechnungsschritt anschließt.

Alternativ schlägt die AT510817A2 vor, die Spannung des Neutralleiters mit einem Referenzwert zu vergleichen, welcher von einem Sternpunkt der drei Phasen abgegriffen wird.

Aus der DE102013016710 ist eine Neutralleiterüberwachung bekannt, bei welcher die Außenleiter mit dem Neutralleiter zu einem virtuellen Sternpunkt zusammengeschaltet wird, und wobei eine Abbildungsschaltung bei einer Unterbrechung des Neutralleiters ein Messignal des Neutralleiters bezogen auf den virtuellen Sternpunkt mit einem Gleichanteil beaufschlagt. Hierzu werden in der Abbildungsschaltung gleichrichtende Elemente verwendet, wodurch die Abbildungsschaltung die positive oder negative Einhüllende der drei Phasen auf den Neutralleiter abbildet. Sämtliche im Netz vorhandenen Frequenzanteile werden durch diese Schaltung herausgefiltert.

Bei keiner der bekannten Methoden erfolgt die Bewertung frequenzabhängig. Eine frequenzabhängige Bewertung erhöht den Schutz bei gleichzeitiger Minimierung von Fehlauslösungen.

Existierende Lösungen können außerdem nur den Neutralleiter bis zum Schutzgerät, nicht aber eine hinter dem Schutzgerät angeordnete Neutralleiterschiene überwachen.

Existierende Lösungen können außerdem nur den Neutralleiter bis zum Schutzgerät, nicht aber eine hinter dem Schutzgerät angeordnete Neutralleiterschiene überwachen.

Dies ist nachteilig, da Fehler, die an der Neutralleiterschiene selber entstehen, also insbesondere Fehler, die zum Beispiel bei Umbauarbeiten im Verteilerkasten entstehen, nicht, oder nur teilweise erkannt werden.

Der vorliegenden Erfindung liegt dabei das Bestreben zugrunde, einen Verlust der Neutralleiterverbindung sowohl auf Einspeise- als auch auf Verbraucherseite zu erkennen.

Außerdem gilt es, eine einfache Messung mit möglichst effektivem Schutz bereit zu stellen.

Diese Aufgaben werden erfindungsgemäß durch die Merkmale der Vorrichtung nach Anspruch 1 oder XXXX gelöst, sowie des Verfahrens nach Anspruch 15. Vorteilhafte Ausgestaltungen der Erfindung sind Gegenstand der abhängigen Ansprüche.

In vorteilhafter Weise wird der Schutz des Neutralleiters in einen Fehlerstromschutzschalter integriert, welcher ohnehin vorgeschrieben ist. Dadurch lässt sich der Schutz erhöhen, ohne zusätzliche Geräte im Verteilerkasten zu erfordern.

Weiterhin lässt sich der Schutz vor Schäden an Anlagen und auch der Personenschutz erhöhen, wenn zusätzlich auch der Schutzleiter PE überwacht wird. Sinnvollerweise geschieht dies ebenfalls frequenzabhängig, so dass der Schutz optimiert wird während Fehlabschaltungen vermieden werden. Dies ist besonders vorteilhaft bei mobilen Fehlerstrom-Schutzeinrichtungen welche zuverlässig auf Baustellen verwendet werden können.

In vorteilhafter Weise kann dabei für den Frequenzbereich von 10 Hz bis 100 Hz eine maximal zulässige Schutzleiterspannung von 25 V vorgesehen werden, so dass auch unter den weiter oben genannten besonderen Bedingungen stets ein zuverlässiger Schutz gegen elektrischen Schlag geboten ist. Im Frequenzbereich von 100 Hz bis 1000 Hz kann ein stetiger Verlauf der maximal zulässigen Schutzleiterspannung von 25 V bei 100 Hz ansteigend auf 50 V bei 1000 Hz vorgesehen sein. Oberhalb von 1000 Hz kann ein stetiger Verlauf der maximal zulässigen Schutzleiterspannung mit demselben Anstieg wie im Frequenzbereich zwischen 100 Hz und 1000 Hz vorgesehen sein. Bevorzugt bleibt der Wert der maximal zulässigen Schutzleiterspannung oberhalb von 1000 Hz in vorteilhafter Weise konstant. Beispielsweise kann bei einer Frequenz von 100 kHz oder 1 MHz somit auch ein Wert von 50 V vorgesehen sein. Im unteren Frequenzbereich von nahezu 0 Hz bis 10 Hz kann ein stetiger Verlauf der maximal zulässigen Schutzleiterspannung von 50 V bei nahezu 0 Hz abfallend auf 25 V bei 10 Hz vorgesehen sein. Für 0 Hz, also DC, kann ein Wert von 50 V oder in bekannter Weise 60 V als Grenzwert vorgesehen sein. In vorteilhafter Weise ergibt sich somit ein größtmöglicher Schutzpegel in Bezug auf den Schutz gegen elektrischen Schlag, wobei insbesondere durch den Anstieg der Kennlinie der maximal zulässigen Schutzleiterspannung oberhalb von 100 Hz sowie unterhalb von 10 Hz eine hohe Immunität gegenüber unerwünschten Ableitströmen auf dem Schutzleiter und somit eine hohe Anlagenverfügbarkeit erreicht wird. Durch den zuvor genannten frequenzabhängigen Verlauf der Kennlinie der maximal zulässigen Schutzleiterspannung ergeben sich über einen weiten Frequenzbereich stets definierte Werte, die zu einer sicheren Abschaltung führen.

Mit Bezug auf die Zeichnungen wird nachfolgend die Erfindung erläutert. Gleiche Bauteile der unterschiedlichen Ausführungsformen sind im Folgenden mit den gleichen Referenzzeichen versehen. Die Beschreibung einer Anordnung, welche sich baugleich in den unterschiedlichen Ausführungsformen wiederfinden, wird im Folgenden nur einmal vorgenommen.
Fig. 1 zeigt ein Blockschaltbild einer ersten Ausführungsform der Vorrichtung zur Erkennung von Fehlerzuständen eines Neutralleiters N;
Fig. 2 zeigt ein Blockschaltbild einer zweiten Ausführungsform der Vorrichtung zur Erkennung von Fehlerzuständen eines Neutralleiters N als Bestandteil einer Fehlerstrom-Schutzeinrichtung;
Fig. 3 zeigt ein Blockschaltbild einer dritten Ausführungsform der Vorrichtung, welche zusätzlich zur Erkennung von Fehlerzuständen eines Schutzleiters PE eingerichtet ist.
Fig. 4 zeigt ein Blockschaltbild einer vierten Ausführungsform der Vorrichtung zur Erkennung von Fehlerzuständen eines Neutralleiters N als Bestandteil einer Fehlerstrom-Schutzeinrichtung welche zusätzlich zur Erkennung von Fehlerzuständen eines Schutzleiters PE eingerichtet ist.
Fig. 5 zeigt eine fünfte Ausführungsform der Vorrichtung von Fehlerzuständen eines Neutralleiters N
Fig. 6 zeigt zwei beispielhafte Verläufe eines frequenzabhängigen Grenzwertes
Fig. 7 zeigt ein Blockschaltbild einer sechsten Ausführungsform der Vorrichtung zur Erkennung von Fehlerzuständen eines Neutralleiters N oder einer Neutralleiterschiene;
Fig. 8 zeigt ein Blockschaltbild einer Weiterbildung der sechsten Ausführungsform der Vorrichtung zur Erkennung von Fehlerzuständen eines Neutralleiters N oder einer Neutralleiterschiene;
Fig. 9 zeigt ein Blockschaltbild einer Weiterbildung der sechsten Ausführungsform der Vorrichtung der erfindungsgemäßen Vorrichtung, welche zusätzlich zur Erkennung von Fehlerzuständen eines Schutzleiters PE eingerichtet ist.
Fig 10 zeigt einen frequenzabhängigen Spannungsteiler, wie er am Eingang einer Auswerteeinheit eines ersten bis fünften Ausführungsbeispiels der Vorrichtung zur Erkennung von Fehlerzuständen eines Neutralleiters N verwendet werden kann um einen frequenzabhängigen Verlauf des frequenzabhängigen Grenzwertes zu erzielen.
Fig 11 zeigt einen frequenzabhängigen Spannungsteiler, wie er am Eingang einer Auswerteeinheit eines sechsten Ausführungsbeispiels der Vorrichtung zur Erkennung von Fehlerzuständen eines Neutralleiters N verwendet werden kann um einen frequenzabhängigen Verlauf des Frequenzabhängigen Grenzwertes zu erzielen.
Fig 12 zeigt eine beispielhafte Ausführungsform eines erfindungsgemäßen Fehlerstromschutzschalters in einer Hausinstallation.

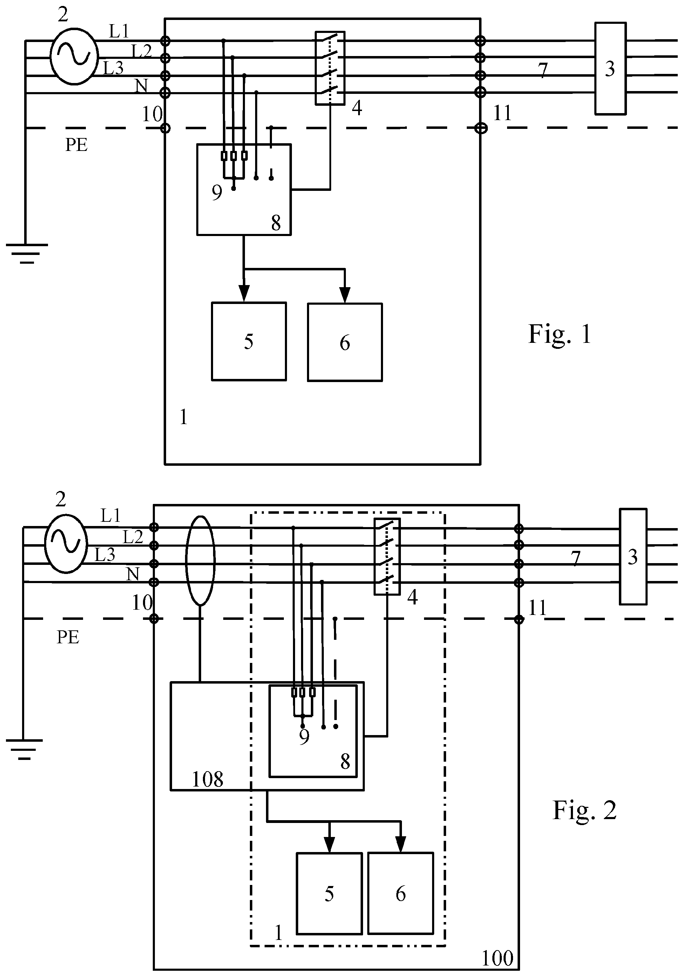

Fig. 1 zeigt eine erste Ausführungsform einer erfindungsgemäße Vorrichtung 1 zur Erkennung von Fehlerzuständen eines Neutralleiters N zur Verwendung in einem dreiphasigen Stromversorgungssystem. Die Vorrichtung 1 ist eingangsseitig über eine Anschlüsse 10 mit der Spannungsquelle 2 verschaltet. Ausgangsseitig ist die Vorrichtung 1 über Anschlüsse 11 mit zumindest einer elektrischen Last 3 verschaltet. Die Vorrichtung 1 umfasst eine Auswerteeinheit 8. Die Auswerteeinheit 8 ist eingangsseitig mit allen Außenleitern 7 der Spannungsquelle L1, L2, L3 und des Neutralleiters N elektrisch verbunden. Optional kann ein Schutzleiter PE vorhanden sein, welcher ebenfalls mit der Last 3 verbunden sein kann. Dieser kann entweder durch die Vorrichtung 1 durchgeführt werden, oder um die Vorrichtung 1 herumgeführt werden In dieser Ausführungsform erfolgt zumindest die Erfassung und Bewertung der Spannung V_{N} des Neutralleiters N durch die Auswerteeinheit 8 frequenzabhängig und über einen weiten Frequenzbereich. Die Vorrichtung 1 umfasst zudem eine erste Schalteinrichtung 4. Die Schalteinrichtung 4 umfasst elektrische Schaltkontakte, die in den Stromleitern 7 der Außenleiter L1, L2, L3 und vorzugsweise des Neutralleiters N angeordnet sind.

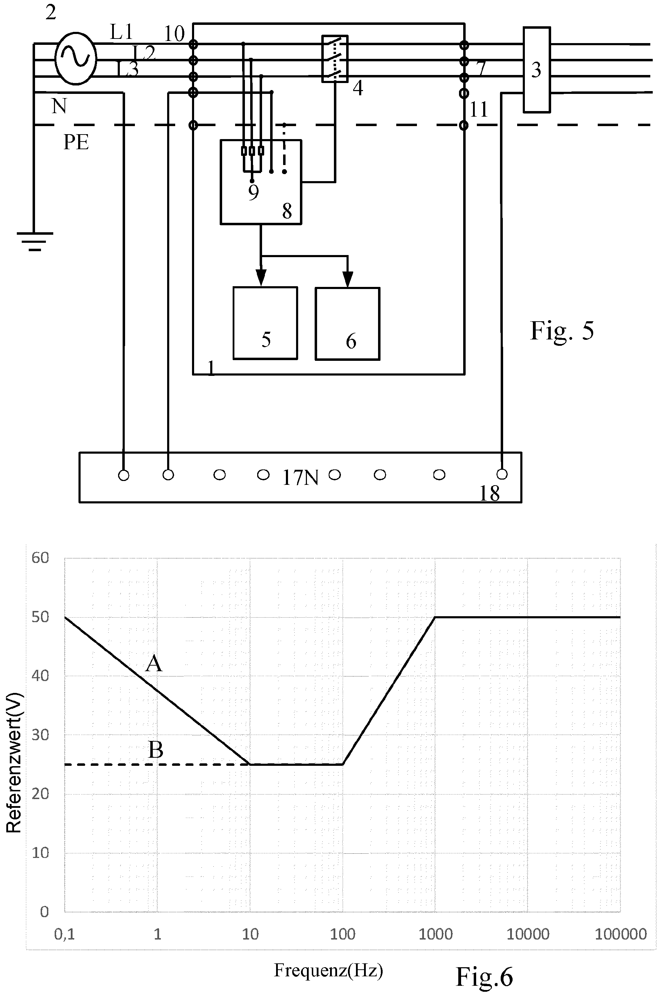

In einer Variante kann der Neutralleiter N durchgängig, also ohne Schaltkontakt ausgeführt sein, oder über eine externe Schiene 17 kontaktiert werden. Diese fünfte Ausführungsform ist in Figur 5 beispielhaft gezeigt. Die Schaltkontakte sind zum elektrischen Öffnen und Schließen der Stromleiter 7 vorgesehen. Die Schalteinrichtung 4 umfasst einen elektrischen Steuereingang, so dass hierdurch ein Öffnen und Schließen der Schaltkontakte ermöglicht werden kann. Die Schaltkontakte sind dazu eingerichtet, dass sie im Wesentlichen gleichzeitig öffnen und schließen. Die Schaltkontakte sind vorzugsweise elektromechanische Schaltkontakte. Optional können die Schaltkontakte auch hybride Schaltkontakte sein, also eine Kombination aus einem oder mehreren Halbleiterbauelementen und einem oder mehreren elektromechanischen Schaltkontakten.

Die Auswerteeinheit 8 ist elektrisch separat mit dem Steuereingang der Schalteinrichtung 4 verschaltet. Weiterhin kann die Vorrichtung 1 über Signalisierungsmittel 5 und/oder eine Kommunikationseinrichtung 6 verfügen. Bei den Signalisierungsmitteln kann es sich um Mittel handeln welche ein sichtbares oder hörbares Signal erzeugen. Die Kommunikationseinrichtung kann dazu eingerichtet sein drahtlos oder drahtgebunden Nachrichten an eine übergeordnete Schalt- und/oder Steuereinheit oder ein mobiles Gerät zu senden. Dabei kann die Nachricht Messwerte und/oder Alarmsignale und/oder Information über die Vorrichtung 1 enthalten. Drahtlose Kommunikation kann dabei alle gängigen Kommunikationssysteme, also zum Beispiel, Wifi, Bluetooth, ZigBee, Funk, Mobiltelefonsysteme, etc. umfassen.

Ein für eine Spannungsmessung des Neutralleiters N erforderliches Bezugspotential kann durch den Schutzleiter PE gebildet werden, falls dieser vorhanden ist.

In diesem Fall kann der Schutzleiter PE durch den Fehlerstromschutzschalter durchgeführt werden. Alternativ kann der Fehlerstromschutzschalter auch über eine Stichleitung, oder gar nicht, mit dem Schutzleiter PE verbunden sein. Alternativ kann das Bezugspotential durch einen aus den Außenleitern L1, L2, L3 gebildeten künstlichen Sternpunkt 9 gebildet werden.

In Abhängigkeit des Zustandes der eingangsseitig verschalteten Außenleiter 7 der Spannungsquelle L1, L2, L3 und des Neutralleiters N und einer daraus erfolgten Bewertung durch die Auswerteeinheit 8 bezüglich eines Fehlerzustandes des Neutralleiters N, wird der Eingang der Schalteinrichtung 4 gesteuert. Eine Messung der Spannung V_{N} des Neutralleiters N erfolgt dabei durch Ermittlung der Potentialdifferenz des Neutralleiters N und des Sternpunktes 9 oder des Schutzleiters PE als Bezugspotential. Wird ein unzulässig hoher Wert der Spannung V_{N} ermittelt, kann die Schalteinrichtung 4 in allen Ausführungsformen so gesteuert werden, dass eine Abschaltung erfolgt. Dies geschieht vorteilhafterweise innerhalb einer bestimmten Zeitspanne, vorzugsweise innerhalb von 1- 10 Perioden der elektrischen Netzfrequenz, zum Beispiel nach 4 Perioden der elektrischen Netzfrequenz, was bei 50 Hz 80 ms entspricht. Vorzugsweise erfolgt die Abschaltung frühestens 70 ms nach Ermittlung eines unzulässig hohen Wertes der Spannung V_{N} und spätestens nach 200ms nach Ermittlung eines unzulässig hohen Wertes der Spannung V_{N}.

In einer zweiten Ausführungsform, ist die Vorrichtung 1 (gestrichelt eingezeichnet) in einen Fehlerstromschutzschalter 100 integriert, wie in Abbildung 2 gezeigt. Der Fehlerstromschutzschalter 100 verfügt dabei über mindestens ein Mittel zum Messen eines Fehlerstroms, hier beispielhaft mindestens einen Summenstromwandler 101. Weiterhin verfügt der Fehlerstromschutzschalter 100 über eine Auswerteeinheit 108, wobei die Auswerteeinheit 8 der Vorrichtung 1 mit der Auswerteinheit 108 integriert sein kann. Es kann sich aber auch um zwei getrennte Auswerteeinheiten handeln, welche über eine Kommunikationsschnittstelle verschaltet sind. Die Auswerteeinheit 108 ist dazu eingerichtet die Signale des Summenstromwandlers oder anderen Mittels zum Messen eines Fehlerstromes aufzubereiten und mit einem Referenzwert zu vergleichen. Bei Auftreten eines Fehlerstroms oberhalb eines, besonders bevorzugt frequenzabhängigen, Referenzwertes, wird der Eingang der Schalteinrichtung 4 gesteuert durch die Auswerteeinheit 108 gesteuert um die Leiter 7 zu öffnen. Bei der Schalteinrichtung 4 kann es sich dabei insbesondere um die im Fehlerstromschutzschalter 100 vorgesehene Trenneinrichtung handeln.

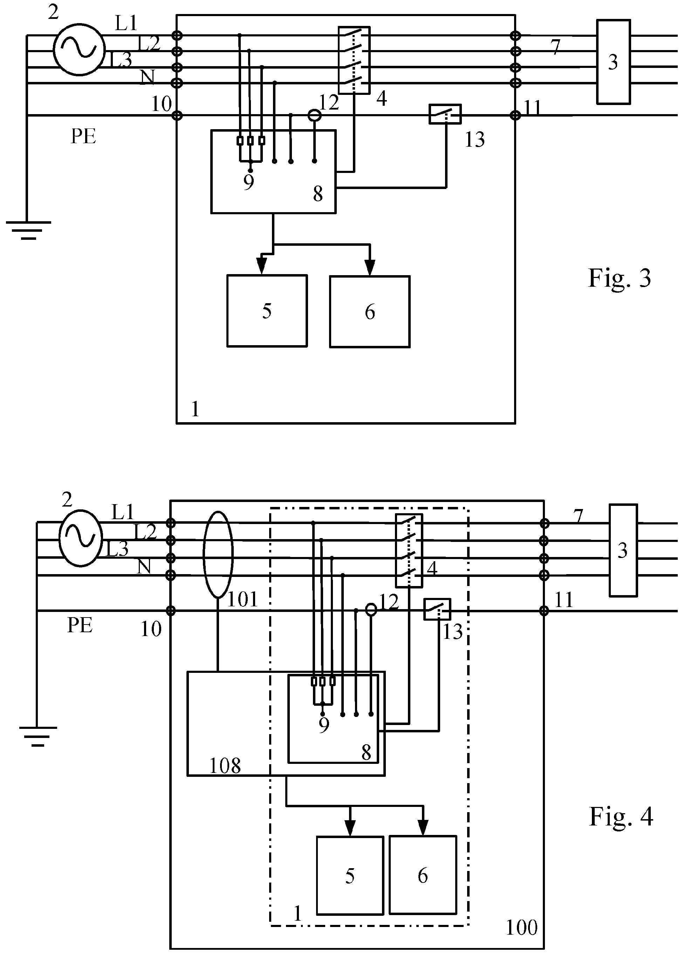

In einer dritten Ausführungsform, welche in Figur 3 dargestellt ist, enthält die Vorrichtung 1 eine Funktionalität zur Überwachung eines Schutzleiters PE. In dieser Ausführungsform wird das Bezugspotential für sowohl den Schutzleiter PE als auch den Neutralleiter N durch den Sternpunkt 9 gebildet. In dieser Ausführungsform verfügt die Vorrichtung zusätzlich über Mittel 12 zum Messen eines Stroms im Schutzleiter PE sowie über ein Schalteinrichtung 13, welche einen elektrischen Schaltkontakt im Schutzleiter PE umfasst. Der Schaltkontakt ist zum Öffnen und Schließen des Schutzleiters PE geeignet. Die Schalteinrichtung 13 umfasst einen elektrischen Steuereingang, so dass hierdurch ein Öffnen und Schließen des Schaltkontakts ermöglicht werden kann. Die Auswerteeinheit 8 ist elektrisch separat mit dem Steuereingang der Schalteinrichtung 13 verschaltet. Vorzugsweise erfolgt auch die Erfassung und Bewertung der Spannung V_{PE} des Schutzleiters PE durch die Auswerteeinheit 8 frequenzabhängig und über einen weiten Frequenzbereich. In Abhängigkeit des Zustandes der eingangsseitig verschalteten Stromleiter 7 der Spannungsquelle L1, L2, L3, N und des Schutzleiters PE sowie eines erfassten Stromes der Strommesseinrichtung 12 und einer daraus erfolgten Bewertung durch die Auswerteeinheit 8 bezüglich eines Fehlerzustandes des Neutralleiters N oder bezüglich eines Fehlerzustandes des Schutzleiters PE werden die Eingänge der Schalteinrichtungen 4 und 13 gesteuert. Wird ein unzulässig hoher Wert der Spannung ermittelt, können die Schalteinrichtungen 4 und 13 so gesteuert werden, dass eine Abschaltung erfolgt. Wird eine Fremdspannung erkannt, z. B. auf einer Baustelle durch Anbohren einer Stromleitung mit einer Bohrmaschine eines anderen fremden Stromkreises, darf keine Abschaltung des Schutzleiters PE erfolgen. In diesem Fall erfolgt nur eine Steuerung zur Öffnung der Schaltkontakte der Schalteinrichtung 4 für die Stromleiter 7 von L1, L2, L3 und N, während der Schaltkontakt der Schalteinrichtung 13 und damit der Stromleiter 7 des Schutzleiters PE geschlossen bleibt. Dadurch ist gewährleistet, dass eine im fremden Stromkreis angeordnete Überstrom-Schutzeinrichtung abschalten kann. Eine Erkennung von Fremdspannung erfolgt in der Art, dass neben einer ermittelten unzulässig hohen Spannung des Schutzleiters PE zudem ein unzulässig hoher Strom im Schutzleiter PE mittels der Strommesseinrichtung 12 erfasst wird. In vorteilhafter Weise erfolgt die Messung und Bewertung des Stromes im Schutzleiter PE über einen weiten Frequenzbereich. Bei dem oben genannten Beispiel des Anbohrens einer fremden Stromleitung fließt ein Strom mit der Netzfrequenz 50 Hz. Die Bewertung des Stromes im Schutzleiters PE kann daher in vorteilhafter Weise so erfolgen, dass nur Frequenzanteile im Strom mit 50 Hz berücksichtigt werden, so dass mögliche Ableitströme im Schutzleiter PE mit weiteren Spektralanteilen, welche durch elektronische bzw. getaktete Betriebsmittel (z.B. Frequenzumrichter) generiert werden können, nicht zur Beeinflussung führen.

Die Vorrichtung 1 der dritten Ausführungsform kann dabei ebenfalls, wie in Figur 4 gezeigt, in einer vierten Ausführungsform in einen Fehlerstromschutzschalter 100 integriert sein. Bei dem Fehlerstromschutzschalter 100 kann es sich hierbei um einen Fehlerstromschutzschalter (RCCB) für Hausinstallation oder um eine ortsveränderliche Fehlerstrom-Schutzeinrichtung (PRCD handeln, wobei die Fehlerstrom-Schutzeinrichtung (PRCD) und die Vorrichtung 1 Bestandteile einer mobilen Einheit, also etwa einer Steckdosenleiste oder eines Baustromverteilers sein können.

Figur 5 zeigt eine fünfte Ausführungsform der Vorrichtung 1, wie sie zum Beispiel in einem Verteilerkasten mit einer Neutralleiterschiene zum Einsatz kommt. Diese Ausführungsform ist zur Verwendung mit Fehlerstromschutzschaltern nicht geeignet, kann aber zum Beispiel als Lasttrennschalter ausgeführt werden. Der Neutralleiter N wird dabei über eine Neutralleiterschiene 17N mit mehreren Anschlüssen 18 geführt. Da der Neutralleiter N dabei nur über einen Abzweig mit der Vorrichtung 1 verbunden ist, ist ein Schalten des Neutralleiters N durch die Schalteinrichtung 4 nicht notwendig.

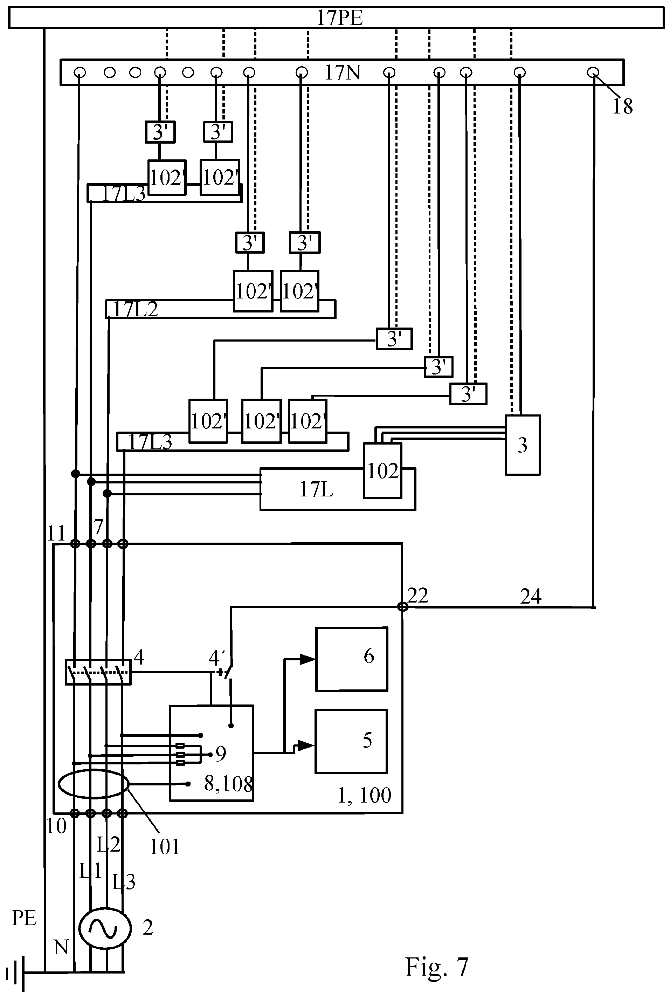

Fig. 7 zeigt eine sechste Ausführungsform einer Vorrichtung 1 zur Erkennung von Fehlerzuständen eines Neutralleiters N zur Verwendung in einem dreiphasigen Stromversorgungssystem, wie sie in einem Verteilerkasten mit einer Neutralleiterschiene zum Einsatz kommt. Die Vorrichtung 1 ist hierbei als Fehlerstromschutzschalter 100 ausgeführt. Der Fehlerstromschutzschalter 100 kann ein Fehlerstromschutzschalter 100 für Hausinstallation (RCCB), wahlweise mit eingebautem Überstromschutz (RCBO), oder eine ortsveränderliche Fehlerstrom-Schutzeinrichtung (PRCD) sein, wobei eine ortsveränderliche Fehlerstrom-Schutzeinrichtung (PRCD) Bestandteil einer mobilen Einheit, also etwa einer Steckdosenleiste oder eines Baustromverteilers sein kann. Der Fehlerstromschutzschalter 100 kann dabei eine beliebige der bekannten Auslösecharakteristiken aufweisen. Es kann sich beispielweise um eine Typ A, AC, B, B+ oder F Charakteristik handeln. Optional kann der Fehlerstromschutzschalter jedes Typs zusätzlich bei glatten Gleichfehlerströmen > 6 mA eine Abschaltung bewirken.

Der Schutzleiter PE kann optional (gestrichelt dargestellt) mit allen oder nur einzelnen elektrischen Lasten Last 3, 3' verbunden sein kann.

In dieser Ausführungsform wird der Neutralleiter N hinter dem Fehlerstromschutzschalter 1 auf eine Neutralleiterschiene 17N geführt. Üblicherweise wird auch der Schutzleiter PE auf eine Verteilerschiene 17PE geführt. Derartige Verteilerschienen sind im Stand der Technik bekannt und verfügen üblicherweise über mehrere Anschlüsse 18, welche in Figur 1 beispielhaft für die Neutralleiterschiene N dargestellt sind.

Die Schalteinrichtung 4 ist in der sechsten Ausführungsform insbesondere die im Fehlerstromschutzschalter vorgesehene Trenneinrichtung. Die Schalteinrichtung 4 umfasst elektrische Schaltkontakte, die in den Stromleitern 7 der Außenleiter L1, L2, L3 und normalerweise des Neutralleiters N angeordnet sind. Alternativ können die elektrischen Schaltkontakte auch nur in den Stromleitern 7 der Außenleiter L1, L2, L3 vorgesehen sein. In diesem Fall wird der Neutralleiter N im Fehlerfall nicht geschaltet.

Die Außenleiter L1, L2, L3 können optional, wie in Fig. 7 dargestellt, jeweils auf eine Verteilerschiene 17L1, 17L2, 17L3 geführt werden. Einpolige Schutz- und Schaltgeräte 102', insbesondere Leitungsschutzschalter (auch als Sicherungsautomaten bekannt), sowie die daran angeschlossenen einphasigen Lasten 3' werden dann an jeweils an eine dieser Verteilerschienen 17L1, 17L2, 17L3, sowie an die Verteilerschienen 17N und optional 17PE, angeschlossen. Für dreiphasige Lasten 3 werden üblicherweise 3-polige Verteilerschienen 17L verwendet. Es ist natürlich auch möglich, auch die 3 Außenleiter L1, L2, L3 sowie den Neutralleiter N auf eine 4-polige Verteilerschiene zu führen. Optional können auch die 3 Außenleiter L1, L2, L3, der Neutralleiter N, sowie der Schutzleiter PE auf eine 5-polige Verteilerschiene geführt werden. Die genaue Aufteilung der Lasten 3, 3' auf die verwendeten Verteilerschienen, sowie die Auswahl der Verteilerschienen wird bei der Erstellung der Installation unter Berücksichtigung der geltenden Errichtungsbestimmungen vom Installateur vorgenommen.

Hierzu verfügt der Fehlerstromschutzschalter 1 über einen zusätzlichen Anschluss 22, welcher dazu vorgesehen ist, dass von der Neutralleiterschiene eine Messleitung 24 zum Fehlerstromschutzschalter zurückgeführt wird, und an diesen Anschluss 22 angeschlossen wird. Der Neutralleiter N und die Messleitung 24 sind dabei vorzugsweise an entgegengesetzten Enden der Neutralleiterschiene 17N angeschlossen. Vorzugsweise ist eine weitere Schalteinrichtung 4' mit einem elektrischen Schaltkontakt in der Leitung angeordnet, welche den Anschluss 22 mit der Auswerteeinrichtung 8 verbindet, vorgesehen. Diese Schalteinrichtung ist vorzugsweise über ein Betätigungselement von Hand schaltbar. Gleichzeitig ist die Schalteinrichtung 4' mit der Schalteinrichtung 4'gekoppelt, so dass der Schaltkontakt der Schalteinrichtung 4'im Wesentlichen gleichzeitig mit dem Schaltkontakt im Neutralleiter N öffnet oder schließt. Die Kopplung der Schalteinrichtung 4' an die Schalteinrichtung 4 ist vorzugsweise, wie dargestellt mechanischer Art, kann aber auch auf elektronische Weise geschehen. Die Öffnung der Schalteinrichtung 4'gescheiht daher vorteilhafterweise ebenfalls innerhalb einer bestimmten Zeitspanne, beispielsweise innerhalb von 1- 10 Perioden der elektrischen Netzfrequenz, besonders vorteilhaft nach 4 Perioden der elektrischen Netzfrequenz, was bei 50 Hz 80 ms entspricht. Vorzugsweise erfolgt die Abschaltung frühestens 70 ms nach Ermittlung eines unzulässig hohen Wertes der Spannung V_{N} und spätestens nach 200ms nach Ermittlung eines unzulässig hohen Wertes der Spannung V_{N}.

Die Auswerteeinheit 8, 108 ist wie in der zweiten Ausführungsform dazu eingerichtet einerseits die Funktionen des Fehlerstromschutzschalters 100 zu steuern und andererseits die Spannung des Neutralleiters N gegenüber einem Bezugspotential zu erfassen und zu bewerten. Dabei kann die Spannung des Neutralleiters V_{N} auf der Einspeiseseite (V_{NE}) und/oder an der Neutralleiter-Schiene 17N (V_{NS}) abgegriffen werden. Hierdurch kann zuverlässig erkannt werden, ob eine Neutralleiterunterbrechung auf Einspeiseseite oder an der Neutralleiterschiene vorliegt.

In der bevorzugten Ausführungsform bewertet die Auswerteeinheit sowohl die Spannung des Neutralleiters V_{N} auf der Einspeiseseite (V_{NE}) als auch die Spannung des Neutralleiters V_{N} an der Neutralleiter-Schiene 17N (V_{NS}). Es ist aber auch möglich wahlweise nur die Spannung auf Einspeiseseite oder auf der Verbraucherseite zu bewerten. Dies kann beispielsweise vom Hersteller festgelegt werden. Alternativ kann die Auswerteeinheit 8, 108 dazu eingerichtet sein, zur Auswahl einen Steuerbefehl zu erhalten, beispielsweise von der Kommunikationseinrichtung 6 oder über einen Wahlschalter des Fehlerstromschutzschalters 100. Der Wahlschalter kann dabei so gestaltet werden, dass er nur von einer dazu berechtigten Person bedient werden kann.

Im Fehlerstromschutzschalter 100 sind auf den entsprechenden Leiterplatten vorzugsweise die jeweiligen Leiterbahnen des Anschlusses für den einspeiseseitigen Neutralleiter N und die am Anschluss 22 angeschlossenen Leiterbahnen ausreichend beabstandet um eine galvanische Trennung zu garantieren. Dies gilt insbesondere dann, wenn die Schalteinrichtung 4 keinen Schaltkontakt im Neutralleiter N aufweist.

Alle Funktionen des Fehlerstromschutzschalters 100 können von einer einzigen Auswerteeinheit 8, 108 übernommen werden. Alternativ können die unterschiedlichen Funktionen auch auf unterschiedliche Auswerteeinheiten 8, 108 aufgeteilt werden, beispielsweise durch Verwendung mehrerer Mikroprozessoren oder Leiterplatten mit elektronischen Schaltungen.

Das Bezugspotential wird vorzugsweise durch einen aus den Außenleitern L1, L2, L3 gebildeten, künstlichen Sternpunkt 9 gebildet werden.

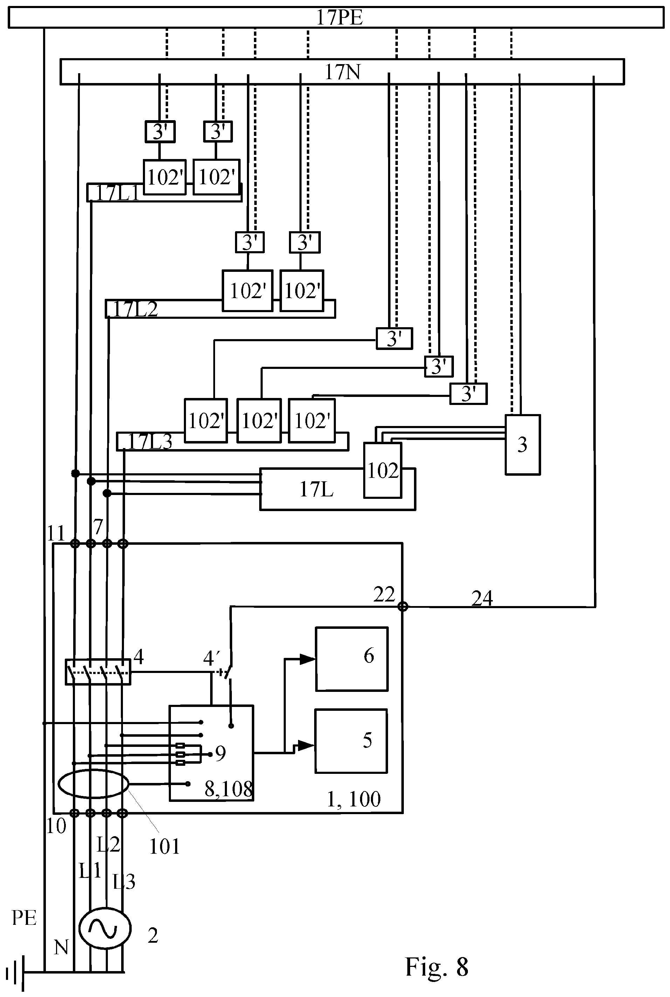

Ein für eine Spannungsmessung des Neutralleiters N erforderliches Bezugspotential kann alternativ auch durch den Schutzleiter PE gebildet werden. In diesem Fall kann der Schutzleiter PE durch den Fehlerstromschutzschalter 100 durchgeführt werden. Alternativ kann der Fehlerstromschutzschalter auch über eine Stichleitung, wie in Fig. 8 abgebildet, oder wie in Fig. 7 dargestellt, gar nicht, mit dem Schutzleiter PE verbunden sein. In den beiden letzteren Fällen kann der Schutzleiter direkt auf eine Schutzleiterschiene 17PE geführt werden.

In einer Weiterbildung der sechsten Ausführungsform kann die Erfassung und Bewertung der Spannung V_{N} des Neutralleiters N durch die Auswerteeinheit 8 frequenzabhängig und über einen weiten Frequenzbereich erfolgen. Die Vorrichtung 1 umfasst zudem eine erste Schalteinrichtung 4. Die Schalteinrichtung 4 umfasst elektrische Schaltkontakte, die in den Stromleitern 7 der Außenleiter L1, L2, L3 und des Neutralleiters N angeordnet sind. Die Schaltkontakte sind zum elektrischen Öffnen und Schließen der Stromleiter 7 vorgesehen. Die Schalteinrichtung 4 umfasst einen elektrischen Steuereingang, so dass hierdurch ein Öffnen und Schließen der Schaltkontakte ermöglicht werden kann. Die Auswerteeinheit 8 ist elektrisch separat mit dem Steuereingang der Schalteinrichtung 4 verschaltet. Weiterhin kann die Vorrichtung 1 über Signalisierungsmittel 5 und/oder die Kommunikationseinrichtung 6 verfügen. Bei den Signalisierungsmitteln kann es sich um Mittel handeln, welche sichtbare und/oder hörbare Signale erzeugen. Hierbei können insbesondere mehrere unterschiedliche Signale verwendet werden, um den ermittelten Ort der Neutralleiterunterbrechung anzuzeigen. Hierzu können zum Beispiel mehrere LEDs unterschiedlicher Farben verwendet werden. Es ist aber auch möglich eine einzelne LED mit unterschiedlichen Blinkfolgen zu verwenden. Bei akustischen Signalen können ebenfalls unterschiedliche Tonsequenzen verwendet werden. Es ist auch möglich mehrere unterschiedliche Sprachsignale zu verwenden.

Die Kommunikationseinrichtung 6 kann dazu eingerichtet sein, drahtlos oder drahtgebunden Nachrichten an eine übergeordnete Schalt- und/oder Steuereinheit oder ein mobiles Gerät zu senden. Dabei können die Nachrichten Messwerte und/oder Alarmsignale und/oder Information über die Vorrichtung 1 enthalten. Die Kommunikationseinrichtung 6 kann außerdem dazu eingerichtet sein, drahtlos oder drahtgebunden Nachrichten von einer übergeordnete Schalt- und/oder Steuereinheit oder einem mobilen Gerät zu empfangen. Dabei können die Nachrichten einzustellende Referenzwerte, Steuerbefehle und/oder Schaltbefehle beinhalten, welche von der Kommunikationseinrichtung 6 an die Auswerteeinrichtung 8 weitergeleitet werden. Insbesondere kann auch eingestellt werden, ob der Neutralleiter (N) auf der Einspeiseseite und/oder die Neutralleiterschiene (17N) auf Fehler überwacht werden soll.

Die Kommunikationseinrichtung 6 und/oder die Auswerteeinrichtung 8 können dabei insbesondere so gestaltet sein, dass Befehle und Änderungen der Referenzwerte nur von einer dazu berechtigten Person vorgenommen werden können.

Drahtlose Kommunikation kann dabei alle gängigen Kommunikationssysteme, also zum Beispiel Wifi, Bluetooth, ZigBee, Funk; etc. umfassen.

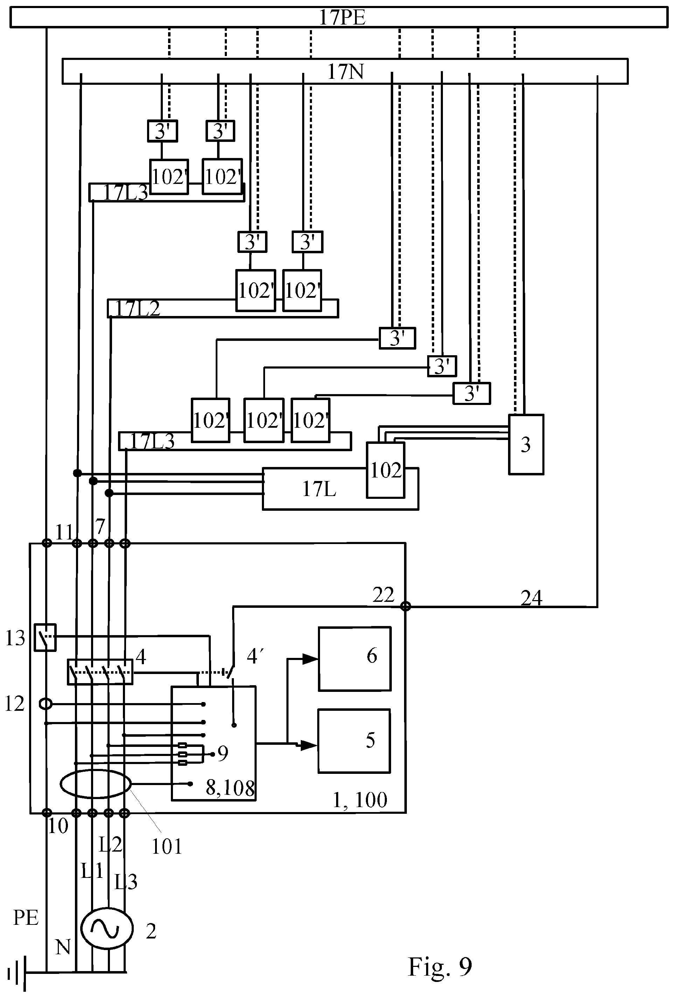

In einer zweiten Weiterbildung der sechsten Ausführungsform, welche in Figur 9 dargestellt ist, enthält die Vorrichtung 1 eine Funktionalität zur Überwachung eines Schutzleiters PE. In dieser Ausführungsform wird das Bezugspotential für sowohl den Schutzleiter PE als auch den Neutralleiter N durch den Sternpunkt 9 gebildet. In dieser Ausführungsform verfügt die Vorrichtung zusätzlich über Mittel 12 zum Messen eines Stroms im Schutzleiter PE sowie über ein Schalteinrichtung 13, welche einen elektrischen Schaltkontakt im Schutzleiter PE umfasst. Der Schaltkontakt ist zum Öffnen und Schließen des Schutzleiters PE geeignet. Die Schalteinrichtung 13 umfasst einen elektrischen Steuereingang, so dass hierdurch ein Öffnen und Schließen des Schaltkontakts ermöglicht werden kann. Diese Ausführungsform ist bevorzugt eine ortsveränderliche Fehlerstrom-Schutzeinrichtung (PRCD), wobei die Fehlerstrom-Schutzeinrichtung (PRCD) Bestandteil einer mobilen Einheit, also etwa einer Steckdosenleiste oder eines Baustromverteilers sein kann. Die Überwachung des Schutzleiters PE dieser Ausführungsform entspricht der Überwachung des Schutzleiters PE der dritten Ausführungsform.

Ob ein Spannungswert V_{NE}, V_{NS}, oder V_{PE} unzulässig hoch ist, wird durch einen Vergleich mit einem Referenzwert bestimmt. Es kann sich hierbei um einen einzelnen festen Referenzwert mit einem Wert von beispielsweise 50 V handeln. Es kann jedoch auch jeder andere Wert als Referenzwert gewählt werden. Der Referenzwert kann auch durch einen Steuerbefehl über die Kommunikationseinrichtung 6 oder über einen Wahlschalter einstellbar sein. Der Wahlschalter, die Kommunikationseinrichtung 6 und/oder die Auswerteeinrichtung 8 können dabei insbesondere so gestaltet sein, dass Befehle und Änderungen der Referenzwerte nur von einer dazu berechtigten Person vorgenommen werden können.

Es kann aber auch ein frequenzabhängiger Referenzwert verwendet werden, wie beispielhaft in Figur 6 gezeigt. Bevorzugt hat der Referenzwert bei einer Frequenz von 50 Hz einen Wert von maximal 25 V und/oder bei DC (0 Hz) einen Wert von maximal 50 V und/oder bei einer Frequenz von 1 kHz der Referenzwert einen Wert von maximal 50 V hat.

In der in Figur 6 in Kennlinie A gezeigten Ausführungsform ist der Referenzwert wie folgt definiert:
Bei 0 Hz ist der Referenzwert 50V
Von 0 - 10 Hz fällt der Referenzwert auf 25V
Von 10 Hz- 100 Hz ist der Referenzwert konstant 25V
Von 100 Hz- 1000 Hz steigt der Referenzwert linear an auf 50 V
Ab 1000 Hz ist der Referenzwert konstant 50V

In der in Figur 6 in Kennlinie B gezeigten Ausführungsform ist der Referenzwert wie folgt definiert:
Von 0 - 100 Hz ist der Referenzwert konstant bei 25V
Von 100 Hz- 1000 Hz steigt der Referenzwert linear an auf 50 V
Ab 1000 Hz ist der Referenzwert konstant 50V

Der frequenzabhängige Referenzwert kann selbstverständlich auch andere Verläufe haben. Insbesondere ist es denkbar, dass der frequenzabhängige Verlauf des Referenzwertes an die Anwendung angepasst ist und/oder dass er eingestellt werden kann. Dies kann durch einen Wahlschalter geschehen oder über eine Software, insbesondere über eine Software in einer Steuereinheit, auf einem Server, und/oder auf einem Mobilgerät. Der Wahlschalter, die Kommunikationseinrichtung 6 und/oder die Auswerteeinrichtung 8 können dabei insbesondere so gestaltet sein, dass Befehle und Änderungen der Referenzwerte nur von einer dazu berechtigten Person vorgenommen werden können. Das Mobilgerät kann dabei drahtlos oder drahtgebunden mit der Auswerteeinheit kommunizieren, und die Vorrichtung 1 kann zu diesem Zweck über eine entsprechende Kommunikationsschnittstelle verfügen. Dabei kann es sich um die bereits erwähnte Kommunikationseinrichtung 6 handeln. Die Kommunikationseinrichtung 6 ermöglicht in diesem Fall eine bi-direktionale Kommunikation. Es ist jedoch auch denkbar, dass eine weitere Kommunikationseinrichtung vorhanden ist. Die Auswerteeinheit 8 kann über einen internen Speicher verfügen, in dem die Referenzwerte abgelegt sind, und in welchem mehrere unterschiedliche Referenzwertverläufe gespeichert sein können.

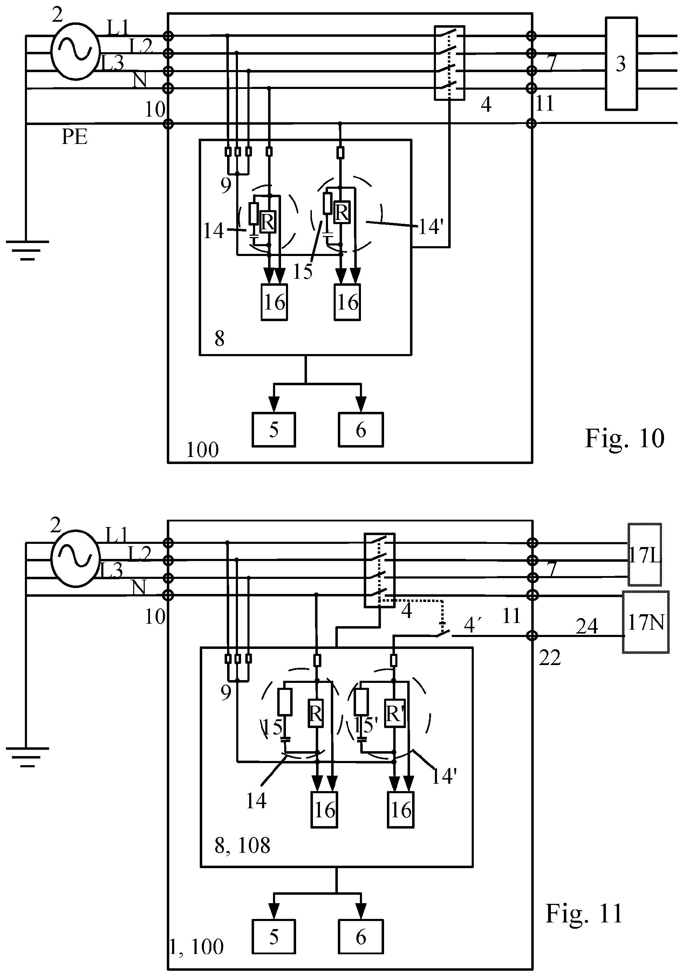

Der frequenzabhängige Verlauf des Referenzwertes lässt sich dabei sowohl durch eine digitale Recheneinheit als auch durch Schaltelemente steuern. In einer beispielhaften Ausführungsform einer Auswerteeinheit 8 in Figur 10 einer Vorrichtung 1 der ersten, zweiten, dritten, vierten oder fünften Ausführungsform wird ein frequenzabhängiger Verlauf des Grenzwertes nach der Kurve B zum Beispiel durch einen am einspeiseseitigen Neutralleiter angeschlossenen, eingangsseitigen Spannungsteiler 14 der Auswerteeinheit 8 erzielt, bestehend aus einem Widerstand R und einem RC-Glied 15. Die Messwerte des Spannungsteilers 14 können in der Folge noch weiteren Schaltelementen 16 zugeführt werden, um den Verlauf weiter zu beeinflussen.

Wird außerdem der Schutzleiter PE in der dritten Ausführungsform als PRCD ebenfalls frequenzabhängig überwacht, wird ein weiterer Spannungsteiler 14' benötigt, welcher ebenfalls an den Sternpunkt 9 angeschlossen wird und andererseits über einen Widerstand an den Schutzleiter PE angeschlossen ist. Wird der Schutzleiter PE als Referenzpotential verwendet, ersetzt der weitere Spannungsteiler den künstlichen Sternpunkt 9. Die Auswerteeinheit 8 kann auch dazu eingerichtet sein, zwischen den Referenzpotentialen umzuschalten. Alternativ kann von vornherein vorgesehen sein, den Schutzleiter PE als Referenzpotential zu verwenden. In diesem Fall kann die Sternpunktbildung 9 entfallen.

Der frequenzabhängige Verlauf des Referenzwertes lässt sich dabei sowohl durch eine digitale Recheneinheit als auch durch Schaltelemente steuern.

In einer beispielhaften Ausführungsform einer Auswerteeinheit 8 in Figur 10 einer Vorrichtung 1 der sechsten Ausführungsform wird ein frequenzabhängiger Verlauf des Grenzwertes nach der Kurve B zum Beispiel durch einen am einspeiseseitigen Neutralleiter angeschlossenen, eingangsseitigen Spannungsteiler 14 der Auswerteeinheit 8 erzielt, bestehend aus einem Widerstand R und einem RC-Glied 15. Die Messwerte des Spannungsteilers 14 können in der Folge noch weiteren Schaltelementen 16 zugeführt werden, um den Verlauf weiter zu beeinflussen.

Wird auch die Neutralleiterschiene 17N frequenzabhängig überwacht, kann ein weiterer Spannungsteiler 14', bestehend aus einem Widerstand R' und einem RC-Glied 15' verwendet.

Wird ein fester Referenzwert vorgesehen, können die RC-Glieder 15, 15' entfallen. In diesem Fall kann die Spannung zwischen dem Sternpunkt 9 und dem einspeiseseitigen Neutralleiter N beziehungsweise zwischen dem Sternpunkt 9 und der Neutralleiterschiene 17N über den Spannungsteiler direkt mit dem festen Referenzwert verglichen werden.

Wird außerdem der Schutzleiter PE in der zweiten Weiterbildung der sechsten Ausführungsform als PRCD ebenfalls frequenzabhängig überwacht, wird ein dritter Spannungsteiler 14' benötigt, welcher ebenfalls an den Sternpunkt 9 angeschlossen wird und andererseits über einen Widerstand an den Schutzleiter PE angeschlossen ist. Wird der Schutzleiter PE als Referenzpotential verwendet, ersetzt er den künstlichen Sternpunkt 9. Die Auswerteeinheit 8 kann auch dazu eingerichtet sein, zwischen den Referenzpotentialen umzuschalten. Alternativ kann von vornherein vorgesehen sein, den Schutzleiter PE als Referenzpotential zu verwenden. In diesem Fall kann die Sternpunktbildung 9 entfallen.

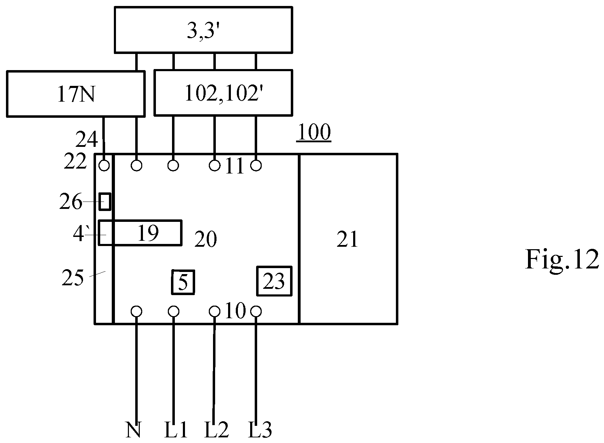

Figur 12 zeigt eine beispielhafte Ausführungsform einer Schalteinrichtung in einer Hausinstallation, welcher die Vorrichtung 1 beinhaltet. Die Schalteinrichtung kann dabei ein Schutzschaltgerät oder eine Schutzschalteinrichtung, also ein Fehlerstromschutzschalter (RCCB), eine Fehlerstromschutzeinrichtung (RCD), ein Leitungsschutzschalter (MCB), ein Fehlerstromschutzgerät mit Überstromschutz (RCBO) oder ein Lasttrennschalter sein. Beispielhaft ist in Fig. 12 ein Fehlerstromschutzschalter 100 in einer Hausinstallation dargestellt. Der Fehlerstromschutzschalter 100 verfügt über ein Isolierstoffgehäuse 20, an welches ein modulares Anbaugehäuse 21 angebaut sein kann. Die Auswerteeinheit 8 kann teilweise oder auch vollständig im Anbaugehäuse 21 untergebracht werden. Es ist aber auch denkbar, die Auswerteeinheit 8 vollständig im Gehäuse 20 unterzubringen. In diesem Fall ist es nicht nötig, ein Anbaugehäuse 21 vorzusehen.

Ein Betätigungselement 19 erlaubt es in fachüblicher Weise, die Schalteinrichtung 4 manuell zu schalten. Ebenfalls ist eine Taste zur Funktionsüberprüfung 23 vorgesehen, welche auf fachübliche Weise die Erzeugung eines Prüfstroms bewirkt, wodurch ein Fehlerstrom simuliert wird.

Ist in der sechsten Ausführungsform eine Messleitung 24 vorhanden, dann wird diese mit dem Anschluss 22 eines handelsüblichen Hilfsschalters 25 verbunden. Die Schalteinrichtung 4'entspricht in diesem Fall dem Betätigungselement des Hilfsschalters 25. Das Betätigungselement des Hilfsschalters 25 lässt sich auf bekannte Weise mit dem Betätigungselement 19 des Fehlerstromschutzschalters verbinden, was eine mechanische Kopplung der jeweiligen Schaltkontakte sicherstellt. Der Hilfsschalter verfügt vorzugsweise über eine Prüftaste 26. Wird diese Taste betätigt, werden die Schaltkontakte des Hilfsschalters geöffnet, was eine Trennung der Auswerteeinrichtung 8 vom Anschluss 22 bewirkt. Ein erfindungsgemäßer Fehlerstromschutzschalter im ordnungsgemäßen Zustand, bei welchem die Erkennung eines Fehlers einer Neutralleiterschiene aktiv ist, erkennt dann den Verlust des Neutralleiters. Vorzugsweise wird der Verlust durch die Signaleinrichtung 5 angezeigt und/ oder führt zum Auslösen des Fehlerstromschutzschalters. In der ersten bis fünften Ausführungsform ist es nicht nötig den Hilfsschalter 25 vorzusehen.

Die Erfindung ist natürlich nicht auf die beschriebenen und in den beigefügten Zeichnungen dargestellten Ausführungsformen begrenzt. Modifikationen bleiben möglich, insbesondere vom Gesichtspunkt der Beschaffenheit der verschiedenen Elemente oder durch Substitution von technischen Äquivalenten, ohne dabei den Schutzbereich der Erfindung, welcher durch die Schutzansprüche definiert ist, zu verlassen.

## Patentansprüche

1. Vorrichtung (1) zur Erkennung von Fehlerzuständen eines Neutralleiters (N) eines dreiphasigen Niederspannungsnetzes, aufweisend:
• eine Auswerteeinheit (8,108) ausgebildet zum Messen und zur Bewertung einer Neutralleiterspannung (V_{N}) zwischen einem Bezugspotential und dem Neutralleiter
• wobei die Auswerteinheit (8,108) zum Erkennen eines Fehlerzustandes des Neutralleiters (N) anhand der Neutralleiterspannung (V_{N}) ausgebildet ist,
**dadurch gekennzeichnet, dass** die Auswerteeinheit (8,108) dazu eingerichtet ist, Fehlerzustände des Neutralleiters (N) auf der Erzeugerseite und/oder Fehlerzustände der Neutralleiterschiene (17N) zu erkennen.

2. Vorrichtung (1) nach Anspruch 1, wobei der Neutralleiter (N) hinter der Vorrichtung (1) an einem ersten Anschluss (18) einer Neutralleiterschiene (17N) angeschlossen ist und eine Messleitung (24) von einem zweiten Anschluss (18) der Neutralleiterschiene (17N) zu einem Anschluss (22) der Vorrichtung (1) geführt ist.

3. Vorrichtung nach einem der vorhergehenden Ansprüche 1 bis 2, **dadurch gekennzeichnet, dass** die Auswerteeinheit (8, 108) einen Fehlerzustand des Neutralleiters (N) erkennt, wenn die Neutralleiterspannung einen frequenzabhängigen Referenzwert überschreitet.

4. Vorrichtung (1) nach einem der vorhergehenden Ansprüche, **dadurch gekennzeichnet, dass** die Auswerteeinheit (8,108) dazu eingerichtet ist, einen Steuerbefehl zu empfangen, mit dem die Überwachung des Neutralleiters (N) auf der Erzeugerseite und/oder der Neutralleiterschiene (17N) an oder ausgeschaltet werden kann, insbesondere wobei dieser Steuerbefehl über eine Kommunikationseinrichtung (6) empfangen werden kann.

5. Vorrichtung (1) zur Erkennung von Fehlerzuständen eines Neutralleiters (N) eines dreiphasigen Niederspannungsnetzes, aufweisend:
• Mittel zur Bildung eines Bezugspotentials
• eine Auswerteeinheit (8, 108) ausgebildet zum Messen und zur Bewertung einer Neutralleiterspannung (V_{N}) zwischen dem Bezugspotential und dem Neutralleiter
• wobei die Auswerteinheit zum Erkennen eines Fehlerzustandes des Neutralleiters (N) anhand der Neutralleiterspannung (V_{N}) ausgebildet ist,
**dadurch gekennzeichnet, dass** die Bewertung frequenzabhängig erfolgt.

6. Vorrichtung nach dem vorhergehenden Anspruch 5, **dadurch gekennzeichnet, dass** die Vorrichtung ein Bestandteil einer Schalteinrichtung, (19) insbesondere eines Lasttrennschalters ist.

7. Vorrichtung (1) nach einem der vorhergehenden Ansprüche 1-6 , aufweisend Mittel (5,6) zum Anzeigen oder Signalisieren eines Fehlerzustandes des Neutralleiters (N) oder der Neutralleiterschiene (17N), optional wobei die Mittel (6) zum Signalisieren des Fehlerzustandes des Neutralleiters (N) oder der Neutralleiterschiene (17N) eine Abschaltung des Niederspannungsnetzes bewirken, wenn ein Fehlerzustand der Neutralleiters (N) oder der Neutralleiterschiene (17N) erkannt wird, wobei die Abschaltung vorzugsweise frühestens 70 ms nach Erkennung des Fehlerzustandes und spätestens nach 200ms nach Erkennung des Fehlerzustandes erfolgt.

8. Vorrichtung (1) nach einem der vorhergehenden Ansprüche 1-7, **dadurch gekennzeichnet, dass** das Bezugspotential zur Ermittlung der Neutralleiterspannung (V_{N}) durch den Schutzleiter (PE) gebildet wird, oder dass das Bezugspotential zur Ermittlung der Neutralleiterspannung (V_{N}) durch einen aus den Außenleitern (L1, L2, L3) gebildeten künstlichen Sternpunkt (9) gebildet wird.

9. Vorrichtung (1) nach einem der vorhergehenden Ansprüche 1-8, **dadurch gekennzeichnet, dass** die Vorrichtung als Fehlerstromschutzschalter 100, RCCB, optional mit Überstromschutz, RCBO, oder als ortsveränderliche Fehlerstrom-Schutzeinrichtung, PRCD, ausgebildet ist, insbesondere wobei der Fehlerstromschutz eine Auslösecharakteristik des Typs A, F, B oder B+ aufweist, insbesondere wobei bei glatten Gleichfehlerströmen > 6 mA eine Abschaltung bewirkt wird.

10. Vorrichtung (1) nach einem der vorhergehenden Ansprüche 1-9, **dadurch gekennzeichnet, dass** die Vorrichtung über eine Schalteinrichtung (4) verfügt, welche einen Steuereingang aufweist, wobei die Auswerteeinrichtung (8) dazu eingerichtet ist, die Schalteinrichtung (4) derart anzusteuern, dass Leiter (7) des dreiphasigen Niederspannungsnetzes getrennt werden, falls ein Fehlerstrom, ein Fehler eines erzeugerseitigen Außenleiters (L1, L2, L3) , ein Fehler eines erzeugerseitigen Neutralleiters (N), und/oder ein Fehler einer Neutralleiterschiene (17N) erkannt wird.

11. Vorrichtung (1) nach Anspruch 1-10, **dadurch gekennzeichnet, dass** die Schalteinrichtung (4) elektrische Schaltkontakte in den Außenleitern (L1, L2, L3) des dreiphasigen Niederspannungsnetzes umfasst, welche dazu eingerichtet sind, im Wesentlichen gleichzeitig zu öffnen und zu schließen, insbesondere wobei die Schalteinrichtung (4) zusätzlich einen Schaltkontakt im Neutralleiter (N) umfasst, wobei der Schaltkontakt im Neutralleiter (N) nach oder gleichzeitig mit den elektrischen Schaltkontakten in den Außenleitern (L1, L2, L3) öffnet und vor oder gleichzeitig mit den elektrischen Schaltkontakten in den Außenleitern (L1, L2, L3) schließt.

12. Vorrichtung (1) nach einem der vorhergehenden Ansprüche 1-11, **dadurch gekennzeichnet, dass** die Auswerteeinheit (8) einen Fehlerzustand des Neutralleiters (N) oder der Neutralleiterschiene (17N) erkennt, wenn die Neutralleiterspannung (V_{N}) einen frequenzabhängigen Referenzwert überschreitet, insbesondere wobei der Referenzwert bei einer Frequenz von 50 Hz der Referenzwert einen Wert von maximal 25 V hat und/oder bei DC (0 Hz) der Referenzwert einen Wert von maximal 50 V hat und/oder bei einer Frequenz von 1 kHz der Referenzwert einen Wert von maximal 50 V hat.

13. Vorrichtung nach Anspruch 1-12, **dadurch gekennzeichnet, dass** der Referenzwert eine anpassbare Frequenzabhängigkeit hat.

14. Verfahren zur Erkennung von Fehlerzuständen eines Neutralleiters (N) eines dreiphasigen Niederspannungsnetzes, mittels einer Vorrichtung nach einem der Ansprüche 1-4 oder 7-13, aufweisend die Schritte:
• Bildung eines Bezugspotentials
• Messen einer Neutralleiterspannung (V_{N}) zwischen dem Bezugspotential und dem Neutralleiter (N) und/oder zwischen dem Bezugspotential und der Neutralleiterschiene (17N)
• Bewertung einer Neutralleiterspannung (V_{NE}) zwischen dem Bezugspotential und dem Neutralleiter (N) auf der Erzeugerseite und/oder einer Neutralleiterschienenspannung (V_{NS}) zwischen dem Bezugspotential und dem Neutralleiterschiene (17N)
• wobei ein Fehlerzustand des Neutralleiters (N) anhand der Neutralleiterspannung (V_{NE}) erkannt wird und ein Fehlerzustand der Neutralleiterschiene (17N) anhand der Neutralleiterschienenspannung (V_{NS}) erkannt wird.

15. Verfahren zur Erkennung von Fehlerzuständen eines Neutralleiters (N) eines dreiphasigen Niederspannungsnetzes, mittels einer Vorrichtung nach einem der Ansprüche 5-13, aufweisend die Schritte:
• Bildung eines Bezugspotentials
• Messen einer Neutralleiterspannung (V_{N}) zwischen dem Bezugspotential und dem Neutralleiter
• Bewertung einer Neutralleiterspannung (V_{N}) zwischen dem Bezugspotential und dem Neutralleiter
• wobei ein Fehlerzustand des Neutralleiters (N) anhand der Neutralleiterspannung (V_{N}) erkannt wird, **dadurch gekennzeichnet, dass** die Bewertung frequenzabhängig erfolgt.
